Europäisches Patentamt

European Patent Office

Office européen des brevets

(19)

(11) EP 0 762 649 A2

(12) **EUROPEAN PATENT APPLICATION**

(43) Date of publication:
12.03.1997 Bulletin 1997/11

(51) Int Cl.$^6$: **H03K 5/04**

(21) Application number: 96306427.4

(22) Date of filing: 05.09.1996

(84) Designated Contracting States:
DE FR GB IT NL

(30) Priority: 05.09.1995 US 3235

(71) Applicant: TEXAS INSTRUMENTS
INCORPORATED
Dallas, Texas 75243 (US)

(72) Inventor: Eplett, Steven Craig
Houston, TX 77096 (US)

(74) Representative: Holt, Michael
Texas Instruments Limited,
Kempton Point,
68 Staines Road West
Sunbury-on-Thames, Middlesex TW16 7AX (GB)

(54) **A pulse detection circuit**

(57)     A pulse detection circuit (20) responds to an intermediate signal transition (at terminal 44) for entering a predetermined state and producing an output signal level (at output terminal 58) having a duration equal to or greater than a predetermined delay period. A signal transition detection circuit (32), responsive to the predetermined state (on lead 62) and an input signal transition (at input terminal 51) from a control circuit (22), latches the input signal transition by either a setting or a resetting of the signal transition detection circuit and thereby producing the intermediate signal transition. Thus the pulse detection circuit latches the transitions in very short width input signal pulses from the control circuit to control a slower operating controlled circuit. Extra transitions are stored until the controlled circuit is ready to respond to another transition.

FIG. 1

**Description**

FIELD OF THE INVENTION

This invention relates to a pulse detection circuit and more particularly to a circuit which stretches an input pulse into an output pulse with a minimum duration.

BACKGROUND OF THE INVENTION

In the prior art, there are control circuits which respond to an input signal to produce an output signal that controls operation of a second circuit. For instance, the control circuit may produce a control signal for enabling and disabling the second circuit. Generally the control circuit and the second circuit are designed to operate at similar speeds so that the second circuit can respond adequately in response to any change in the control signal.

There are some circuit arrangements, however, in which the control and controlled circuits are not so well coordinated with one another. For example, consider a control circuit that operates at a very high speed and produces output pulses with a duration of no more than 2-3 ns (nano-seconds) and a controlled circuit that is relatively slower acting such as a voltage supply pump circuit. Turning the supply pump circuit on and off may take as long as 20 ns. For adequate charge pumping to ensure the required supply voltage, the voltage supply pump circuit should be turned on in response to every control signal pulse. The relatively slower voltage supply pump circuit will miss responding to some of the very fast control pulses. This will result in a failure to maintain the required supply voltage for operating the overall circuit arrangement on a semiconductor chip.

SUMMARY OF THE INVENTION

The aforementioned problem is resolved by a pulse detection circuit that includes a signal transition detection circuit which is responsive to an intermediate signal transition for entering a predetermined state and producing an output signal level having a duration equal to or greater than a predetermined delay period. The signal transition detection circuit, responsive to the predetermined state and an input signal transition from a control circuit, latches that input signal transition by either setting or resetting the signal transition detection circuit and thereby produces the intermediate signal transition.

An advantage of the pulse detection circuit is that it latches the transitions in very short width pulses from the control circuit to control a slower operating controlled circuit. This ensures that a quick series of transitions of the input signal from the control circuit originating from the pulse detection circuit produce the same number of output transitions, but at a rate within the response capability of the controlled circuit.

BRIEF DESCRIPTION OF THE DRAWINGS

The present invention will now be further described, by way of example, with reference to the accompanying drawings in which:

FIGURE 1 is a logic diagram of a pulse detection circuit arranged in accordance with the present invention;

FIGURE 2 is a state diagram which presents a sequential logic diagram, or a sequence of states that are stepped through by the pulse detection circuit of FIGURE 1;

FIGURE 3 is a schematic diagram of a circuit that can be used to implement the embodiment of FIGURE 1;

FIGURE 4 is a schematic diagram of another circuit that can be used to implement the embodiment of FIGURE 1; and

FIGURE 5 is a generalization of the invention that allows for an arbitrary number of transitions to be buffered.

DETAILED DESCRIPTION

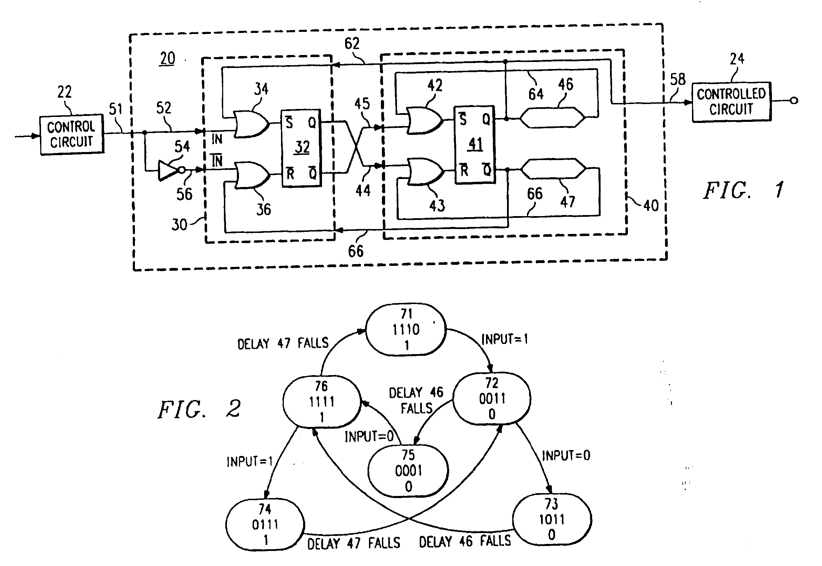

Referring now to FIGURE 1, there is a pulse detection circuit 20, which includes a signal transition detection circuit 30 and a pulse stretcher arrangement 40. A control circuit 22 produces an input signal IN that includes pulses for controlling a much slower controlled circuit 24. The input signal IN, which may include very short pulse widths and rapidly occurring successive transitions, is applied through an input terminal 51 and directly by way of a lead 52 to an input of the signal transition detection circuit 30. Simultaneously, the input signal IN is inverted by an inverter 54, and the inverted input signal is applied by way of a lead 56 to another input of the signal transition detection circuit 30. The input signal transitions cause the pulse detection circuit 20, a sequential logic circuit, to step through a sequence of predetermined states. During each state of the pulse detection circuit 20, an output signal is produced upon an output terminal 58 for controlling the controlled circuit 24, which operates or responds much slower than the control circuit 22.

The input transition detection circuit 30 includes a flip-flop circuit 32 and a pair of OR gates 34, 36. The flip-flop circuit 32 has a low level signal reset input terminal and a low level signal set input terminal. Inputs to those terminals are through the OR gates 36 and 34, respectively. Each of the OR gates 34, 36 produces an output logic "one" or high state if either or both of the inputs is at the logic "one" level. When both inputs are at the logic "zero" level or low state, the output is the logic "zero" level. The flip-flop circuit 32 is set to a logic "one" signal state and produces a logic "one" on it's output terminal Q when a logic "zero" signal is applied to the input terminal . Conversely flip-flop circuit 32 is reset to a "zero" state and produces a logic "zero" signal on the output terminal Q when a logic "zero" signal is applied to the input terminal. The signal produced on the output terminal Q of the flip-flop circuit 32 is an intermediate signal in the pulse detection circuit 20. A complement of the intermediate signal on the output terminal Q is produced on the output terminal $\overline{Q}$.

The pulse stretcher arrangement 40 includes a double OR gate 42, 43 and flip-flop circuit 41 configuration similar to the signal transition detection circuit 30. The intermediate signal from the true output Q of the circuit 30 is applied through a lead 44 to an input to the OR gate 43 that controls the input terminal of the flip-flop circuit. A complement of the intermediate signal from the complementary output $\overline{Q}$ of the circuit 30 is applied through a lead 45 to an input of the OR gate 42 that controls the input terminal of the flip-flop circuit 41.

Within the pulse stretcher arrangement 40, the true and complementary output terminals Q and $\overline{Q}$ produce, respectively, the true and complement signals, "one" and "zero", for the "one" state of the flip-flop circuit 41. A delay element 46 is interconnected between the output terminal $\overline{Q}$ of the flip-flop circuit 41 and a second input of the OR gate 42 to provide a delayed feedback signal to the OR gate 42. Similarly another delay element 47 is interconnected between the output terminal $\overline{Q}$ of the flip-flop circuit 41 and a second input to the OR gate 43 for providing another delayed feedback signal to the OR gate 43. The delay elements 46 and 47 are slow to output a "zero", in response to the input going low, but are quick to output a "one" when the input goes high. The delay in producing a "zero" output is determined by response time of the controlled circuit 24.

The output terminal 58 of the pulse detection circuit 20 is connected with the true output terminal Q of the flip-flop circuit 41. This same true output terminal Q is connected through a lead 62 to feedback the output signal produced on terminal 58 to a second input of the OR gate 34 of the signal transition detection circuit 30. Similarly the complement signal produced at the output terminal $\overline{Q}$ is fed back to a second input of the OR gate 36 of the signal transition detection circuit 30.

Referring now to both FIGURE 1 and FIGURE 2, which is a predetermined sequential logic state diagram for the circuit 20 disclosed in FIGURE 1, the operation of the circuit 20 is described stepping through the several predetermined steps in the sequence.

In FIGURE 2, each state is represented by an elliptically shaped bubble including some numbers. At the top center of each ellipse, the state is identified by a two digit decimal number, e.g., 71-76. There are four binary digits also located within each ellipse. Each of the four binary digits represents a signal level at a different node within the circuit 20 of FIGURE 1. Reading from left to right, the binary digits represent the signal levels on the nodes, or leads, 44, 62, 64 and 66, respectively. At the bottom center of the ellipse, there is another binary digit that represents the logic signal level on the output terminal 58 of the circuit 20 for the predetermined state.

Commencing the description of the sequence of predetermined states, we first consider the state 71 which is a stable state whenever the input signal on the input terminal 51 is the low logic level, or a "zero". In state 71, the flip-flops 32 and 41 are set in their one state producing high signals, or "ones", on their output terminals Q and on the leads 44 and 62. The leads 64 and 66, respectively, have a high signal level and a low level signal thereon in the stable state. Thereafter when the input signal "ON" the input terminal 51 rises to the high logic level, or a "one", both of the flip-flops 32 and 41 are reset to their "zero" state and the circuit moves or steps from the state 71 into the state 72.

The state 72 is an unstable state that produces the low level signal, or "zero" at the outputs Q of the flip-flops 32 and 41 and on the leads 44 and 62, as represented by the two leftmost binary digits in the ellipse representing the state 72. The low level on lead 44 stores the high level on 51 internally. The signals on the leads 64 and 66 are at the high level (i.e. "ones"). The output signal on the output lead 58 of the circuit 20 is at the low level, or "zero". The transition of the output lead 58 from the high level in the previous state 71 to current low level in state 72 is caused by the internally stored rising level of 51. Since the state 72 is unstable either one of two events, to be described, will cause the circuit 20 to step to the next sequential state.

If the circuit 20 is in the state 72 when a low level signal, or "zero", is applied to the input terminal 51, the circuit 20 steps to state 73. The flip-flop 41 remains reset in its "zero" state. A high level signal occurs at the output Q on the lead 44, and a low level occurs at the output Q on the lead 62. The high level on lead 44 stores the low level on 51 internally. The signals on the leads 64 and 66 remain at the high logic level. The low level signal remains on the output terminal 58. State 73 is an unstable state, from which exiting is to be described subsequently herein.

If the circuit 20 is in the state 72 and the signal on the lead 64 at the output of the delay element 46 falls from the high logic level to the low logic level before a "zero" is applied to the input terminal 51, the circuit 20 steps to state 75 rather than to state 73. State 75 is an analogue or complement of state 71 except that state 75 also is stable after the signal on the input terminal 51 goes to the low logic level, or "zero". In state 75 the flip-flops 32 and 41 are reset so that the signals at their output terminals Q on the leads 44 and 62 both are at the low level, or "zero". The signals on the leads 64 and 66, respectively, are at the low and high logic levels. The output signal on the output terminal 58 is at the low logic level, or "zero", during the state 75. Circuit 20 stays in the stable state 75 until the input signal on the lead 51 goes to the low logic level, or "zero", upon which occurrence the circuit 20 steps to the unstable state 76.

Referring back to the state 73, the circuit 20 steps out of the state 73 and into the state 76 when the signal out of the delay element 46 on the lead 64 falls from the high logic level to the low logic level, or "zero". By remaining in state 73 until the delay element 46 outputs a "zero" on the lead 64, the output terminal 58 is maintained at a low level long enough to allow the controlled circuit 24 to operate.

During the state 76, both of the flip-flops 32 and 41 are set to "one" and produce high logic level signals, or "ones", on the leads 44 and 62. Signals on the leads 64 and 66 and on the output terminal 58 are at the high logic level. If the signal from the delay circuit 47 on the lead 66 falls from the high logic level to the low logic level, or "zero", before the input signal on the input terminal 51 goes to the high logic level, the circuit 20 steps on the state 71 which was described previously.

If during the state 76 the input signal on the input terminal 51 goes to the high logic level before the signal on the lead 66 falls to the low logic level, the circuit 20 steps to the unstable state 74. In state 74, the flip-flop 32 is reset to it's "zero" state and the flip-flop 41 is set to it's "one" state. Signals on the leads 44 and 62, respectively, are the low logic level and the high logic level. The low level on lead 44 stores the high level on 51 internally. Signals on the leads 64 and 66 are at the high level. The circuit 20 remains in the state 74 until the signal from the delay element 47 on the lead 66 falls to the low logic level, or "zero". By remaining in state 74 until the delay element 47 outputs a "zero" on the lead 66, the output terminal 58 is maintained at a high level long enough to allow the controlled circuit 24 to operate.

Circuit 20 steps from the state 74 to the unstable state 72 when the signal on the lead 66 falls to the low level. State 72 has been described previously herein.

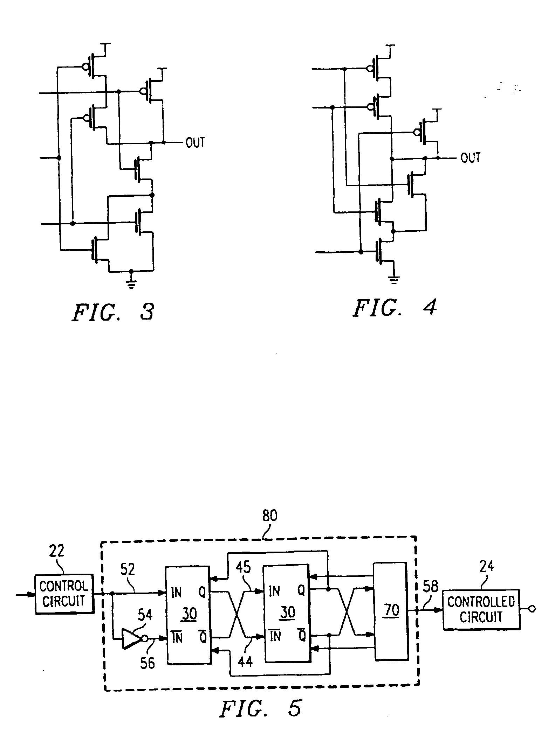

Referring now to FIGURES 3 and 4, there are shown two different circuit arrangements which can be used to construct the pulse detection circuit 20. Each of the FIGURES 3 and 4 presents an OR gate having its output connected to one input of a two input NAND gate. In the pulse detection circuit 20 of FIGURE 1, two of the circuits of FIGURE 3 or of the FIGURE 4 are cross connected to form each of the flip-flops with the two OR gates. That is, the output of each NAND gate is connected to the second input of the other NAND gate. Output terminals $Q$ and $\overline{Q}$ are taken separately from the two NAND gates.

Referring now to FIGURE 5, there is shown an arrangement wherein two of the signal transition detection circuits 30 are connected in tandem with each other and further in tandem with a pulse stretcher circuit 70. The pulse stretcher circuit 70 is similar to the pulse stretcher circuit 40 of FIGURE 1 except that leads feeding back go to the last signal transition circuit 30 rather than to the first signal transition circuit in line. This arrangement of FIGURE 5 provides a pulse detection circuit 80 that will latch, or buffer, a single additional input signal edge, or transition, more than the pulse detection circuit arrangement presented in FIGURE 1.

Each additional input transition detection circuit 30 that is placed in tandem with the others will latch, or buffer, an additional edge, or transition, of the input signal applied to the input signal lead 52.

While this invention has been described with reference to illustrated embodiments, this description should not be construed in a limiting sense. Various modifications of the illustrated embodiments, will be apparent to the skilled person following reference to this description.

## Claims

1. A circuit comprising:

   pulse stretching means responsive to in an intermediate signal transition, for entering a predetermined state and producing an output signal level having a duration substantially equal to or greater than a specific delay time; and
   a signal transition detection circuit, responsive to the predetermined state and an input signal transition, for latching the input signal transition by either setting or resetting of the signal transition detection circuit and thereby producing the intermediate signal transition.

2. The circuit according to Claim 1 further comprising:
   a plurality of signal transition detection circuits, connected in tandem and responsive to the predetermined state and a plurality of input signal transitions, for latching the plurality of input signal transitions by setting or resetting the plurality of signal transition detection circuits and producing the intermediate signal transition for each of the input signal transitions.

FIG. 1

FIG. 2

5

FIG. 3

FIG. 4

FIG. 5